(19) Europäisches Patentamt
European Patent Office
Office européen des brevets

(11) **EP 4 535 054 A1**

(12) **EUROPEAN PATENT APPLICATION**
published in accordance with Art. 153(4) EPC

(43) Date of publication:
**09.04.2025 Bulletin 2025/15**

(21) Application number: **23815764.8**

(22) Date of filing: **16.05.2023**

(51) International Patent Classification (IPC):
*G02B 6/32* (2006.01)    *B23K 26/064* (2014.01)
*G02B 6/42* (2006.01)    *H01S 5/40* (2006.01)

(52) Cooperative Patent Classification (CPC):
**B23K 26/064; G02B 6/32; G02B 6/42; H01S 5/40**

(86) International application number:
**PCT/JP2023/018220**

(87) International publication number:
**WO 2023/234004 (07.12.2023 Gazette 2023/49)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **02.06.2022 JP 2022090109**

(71) Applicant: **SHIMADZU CORPORATION**
**Kyoto-shi, Kyoto 604-8511 (JP)**

(72) Inventors:
• **SUWA, Masaya**
**Kyoto-shi, Kyoto 604-8511 (JP)**
• **ISHIGAKI, Naoya**
**Kyoto-shi, Kyoto 604-8511 (JP)**

(74) Representative: **Müller-Boré & Partner**
**Patentanwälte PartG mbB**
**Friedenheimer Brücke 21**
**80639 München (DE)**

(54) **LASER LIGHT IRRADIATION DEVICE AND LASER PROCESSING DEVICE**

(57)    A laser beam irradiation apparatus (1) includes a plurality of laser light sources (10), an optical fiber (30), and a coupling optical system (20). The coupling optical system (20) includes a reduction optical system (22). The reduction optical system (22) includes a lens (23a) and a lens (24a). The lens (23a) is made of a first glass material. The lens (24a) is made of a second glass material. A second energy gap of the second glass material is greater than a first energy gap of the first glass material.

FIG.1

**Description**

TECHNICAL FIELD

The present disclosure relates to a laser beam irradiation apparatus and a laser processing apparatus.

BACKGROUND ART

Japanese Patent Laying-Open No. 2007-163947 (PTL 1) discloses a multiplexing optical system that couples a plurality of laser beams emitted from a plurality of semiconductor lasers to an optical fiber.

CITATION LIST

PATENT LITERATURE

PTL 1: Japanese Patent Laying-Open No. 2007-163947

SUMMARY OF INVENTION

TECHNICAL PROBLEM

An object of a first aspect of the present disclosure is to provide a laser beam irradiation apparatus capable of stably coupling a laser beam emitted from each of a plurality of laser light sources to an optical fiber over a longer period of time. An object of a second aspect of the present disclosure is to provide a laser processing apparatus capable of stably processing a workpiece over a longer period of time.

SOLUTION TO PROBLEM

A laser beam irradiation apparatus of the present disclosure includes a plurality of laser light sources, an optical fiber, and a coupling optical system. The plurality of laser light sources each emit a laser beam. The coupling optical system is disposed between the plurality of laser light sources and the optical fiber, and couples the laser beam to the optical fiber. The coupling optics include a reduction optical system. The reduction optical system includes a first lens and a second lens. The first lens is disposed closer to the plurality of laser light sources than the second lens on an optical path of the laser beam. A second beam cross-sectional area of the laser beam on an exit surface of the second lens is smaller than a first beam cross-sectional area of the laser beam on an input surface of the first lens. The first lens is made of a first glass material. The second lens is made of a second glass material. A second energy gap of the second glass material is greater than a first energy gap of the first glass material.

A laser processing apparatus of the present disclosure includes the laser beam irradiation apparatus according to the present disclosure.

ADVANTAGEOUS EFFECTS OF INVENTION

According to the laser beam irradiation apparatus of the present disclosure, the laser beam emitted from each of the plurality of laser light sources can be stably coupled to the optical fiber over a longer period of time. According to the laser processing apparatus of the present disclosure, a workpiece can be stably processed over a longer period of time.

BRIEF DESCRIPTION OF DRAWINGS

Fig. 1 is a schematic diagram illustrating a laser beam irradiation apparatus according to an embodiment;
Fig. 2 is a schematic perspective view illustrating an example laser light source included in the laser light irradiation apparatus according to the embodiment;
Fig. 3 is a graph illustrating a light intensity distribution in a fast axis direction of a laser beam emitted from a laser light source included in the laser beam irradiation apparatus according to the embodiment;
Fig. 4 is a graph illustrating a light intensity distribution of a laser beam emitted from a laser light source included in the laser beam irradiation apparatus according to the embodiment in a slow axis direction;
Fig. 5 is a schematic diagram illustrating a laser beam irradiation apparatus according to a modification of the embodiment;

Fig. 6 is a schematic diagram illustrating a laser beam irradiation apparatus according to an embodiment; and

Fig. 7 is a graph illustrating changes over time of an optical output of a laser beam irradiation apparatus according to an example and a comparative example.

DESCRIPTION OF EMBODIMENTS

Hereinafter, an embodiment of the present disclosure will be described. The same reference numerals denote the same components, and the description thereof will not be repeated.

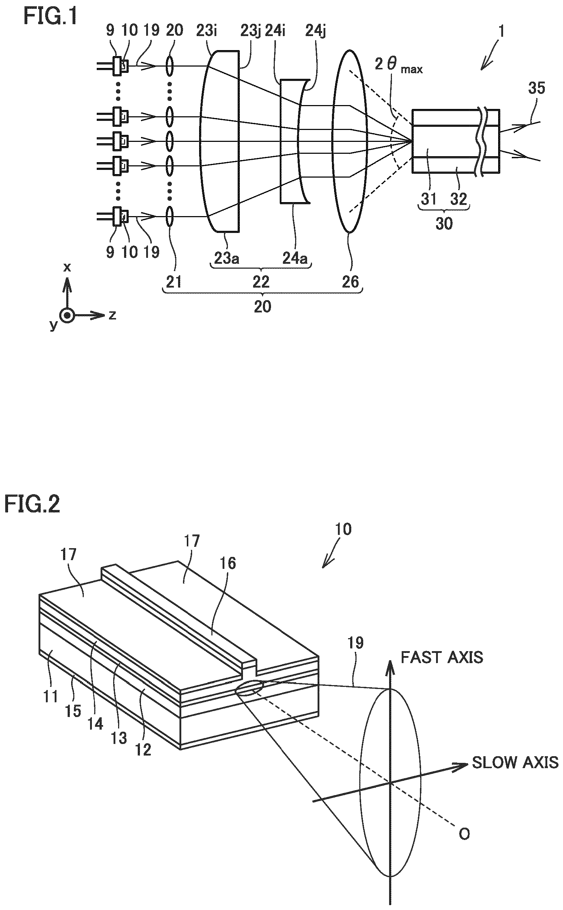

A laser beam irradiation apparatus 1 according to an embodiment will be described with reference to Figs. 1 to 4. The laser beam irradiation apparatus 1 includes a plurality of laser light sources 10, a coupling optical system 20, and an optical fiber 30. The laser beam irradiation apparatus 1 may further include a plurality of packages 9.

Each of the plurality of packages 9 accommodates a corresponding laser light source 10 of the plurality of laser light sources 10. Each of the plurality of packages 9 is, for example, a TO-CAN package.

Each of the plurality of laser light sources 10 emits a corresponding laser beam of the plurality of laser beams 19. The plurality of laser beams 19 have, for example, the same wavelength. Each of the plurality of laser beams 19 has, for example, a wavelength of 380 nm or more and 550 nm or less. Each of the plurality of laser light sources 10 is, for example, a continuous wave (CW) laser light source. Each of the plurality of laser light sources 10 is, for example, a high-power laser light source having an optical output of 5 W or more. The plurality of laser light sources 10 as a whole have an optical output of 1 kW or more, for example.

As illustrated in Fig. 2, each of the plurality of laser light sources 10 is, for example, a laser diode. The laser diode includes a substrate 11, a lower cladding layer 12, an active layer 13, an upper cladding layer 14, electrodes 15 and 16, and an insulating layer 17. The lower cladding layer 12 is formed on the substrate 11. The active layer 13 is formed on the lower cladding layer 12. The upper cladding layer 14 is formed on the active layer 13. The active layer 13 is sandwiched between the lower cladding layer 12 and the upper cladding layer 14. The electrode 15 is formed on the substrate 11. The electrode 15 may be formed on the lower cladding layer 12 instead of being formed on the substrate 11. The electrode 16 is formed on the upper cladding layer 14.

When an electric current is injected into the active layer 13 through the electrode 15 and the electrode 16, the laser beam 19 is emitted from an end face of the active layer 13. In a cross section perpendicular to an optical axis O of the laser beam 19, the laser beam 19 has an elliptical shape. In a cross section perpendicular to the optical axis O of the laser beam 19, the fast axis direction of the laser beam 19 is identical to the thickness direction of the active layer 13, and the slow axis direction of the laser beam 19 is identical to the width direction of the active layer 13. The x-axis direction illustrated in Fig. 1 is identical to the fast-axis direction of the laser beam 19. The y-axis direction illustrated in Fig. 1 is identical to the slow axis direction of the laser beam 19. The z-axis direction illustrated in Fig. 1 is identical to the optical axis direction of the laser beam 19.

The plurality of laser light sources 10 each may be a solid state laser or a fiber laser. The cross-sectional shape of the laser beam 19 in the cross section perpendicular to the optical axis O of the laser beam 19 is not limited to an ellipse, and may be a circle or the like.

As illustrated in Fig. 1, the coupling optical system 20 is disposed between the plurality of laser light sources 10 and the optical fiber 30. The coupling optical system 20 couples the laser beam 19 emitted from each of the plurality of laser light sources 10 to the optical fiber 30. The coupling optical system 20 includes a plurality of collimating lenses 21, a reduction optical system 22, and a condenser lens 26.

The plurality of collimating lenses 21 are disposed between the plurality of laser light sources 10 and the reduction optical system 22. Each of the plurality of collimating lenses 21 is provided for a corresponding one of the plurality of laser light sources 10. Each of the plurality of collimating lenses 21 collimates a corresponding one of the plurality of laser beams 19. The plurality of collimating lenses 21 are made of, for example, the same glass material as a lens 23a which will be described later. In other words, the plurality of collimating lenses 21 are made of, for example, a first glass material which will be described later.

The reduction optical system 22 reduces an interval between the plurality of laser beams 19. Therefore, the reduction optical system 22 allows the plurality of laser beams 19 to enter within a numerical aperture NA of the optical fiber 30. The reduction optical system 22 includes a lens 23a and a lens 24a. The lens 23a is disposed closer to the plurality of laser light sources 10 than the lens 24a on an optical path of the laser beam 19. The lens 23a is disposed between the plurality of laser light sources 10 and the lens 24a on the optical path of the laser beam 19.

The lens 23a has an input surface 23i and an exit surface 23j. The lens 23a has positive power. The lens 23a is, for example, a plano-convex lens having a convex surface facing the plurality of laser light sources 10.

The lens 24a has an input surface 24i and an exit surface 24j. The lens 24a has negative power. The lens 24a is, for example, a plano-concave lens having a concave surface facing the optical fiber 30.

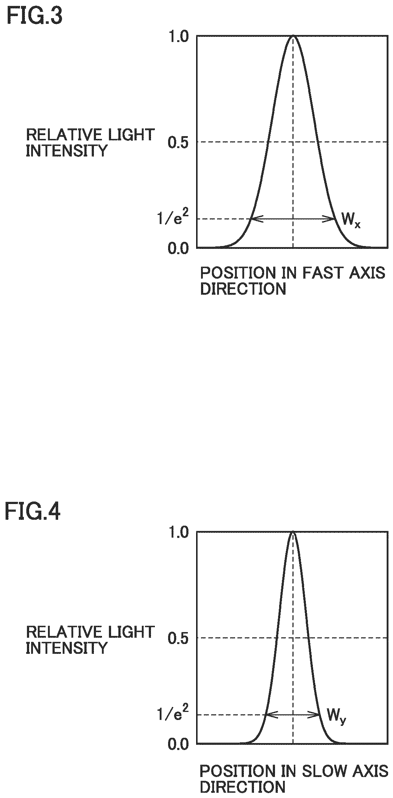

In the present embodiment, the reduction optical system 22 reduces the interval between the plurality of laser beams 19 in the fast axis direction (x direction) and reduces the beam size (for example, the beam diameter) of each of the plurality of laser beams 19 in the fast axis direction. Therefore, the second beam cross-sectional area of each of the plurality of laser beams 19 on the exit surface 24j of the lens 24a is smaller than the first beam cross-sectional area of each of the plurality of laser beams 19 on the input surface 23i of the lens 23a. In the present specification, the cross-sectional area of the laser beam 19 is an area of a region of the laser beam 19 where the light intensity of the laser beam 19 is $1/e^2$ of the peak light intensity of the laser beam 19 in the cross section perpendicular to the optical axis of the laser beam 19. For example, when the laser beam 19 has an elliptical shape, the region of the laser beam 19 where the light intensity of the laser beam 19 is $1/e^2$ of the peak light intensity of the laser beam 19 has an elliptical shape with a major axis $W_x$ (see Fig. 3) in the fast axis direction and a minor axis $W_y$ (see Fig. 4) in the slow axis direction. Therefore, the cross-sectional area of the laser beam 19 is given by the area of an ellipse with a major axis $W_x$ and a minor axis $W_y$.

A second power density of the laser beam 19 on the exit surface 24j of the lens 24a is greater than a first power density of the laser beam 19 on the input surface 23i of the lens 23a. The first power density of the laser beam 19 on the input surface 23i of the lens 23a is, for example, less than 300 W/cm². The second power density of the laser beam 19 on the exit surface 24j of the lens 24a is, for example, 300 W/cm² or more. The second power density of the laser beam 19 on the exit surface 24j of the lens 24a is, for example, equal to or greater than twice the first power density of the laser beam 19 on the input surface 23i of the lens 23a. In the present specification, the power density of the laser beam 19 is obtained by dividing the power of the laser beam 19 by the cross-sectional area of the laser beam 19.

The lens 23a is made of a first glass material. The lens 24a is made of a second glass material. A second energy gap of the second glass material is greater than a first energy gap of the first glass material. For example, the first energy gap is equal to or less than 6.6 eV, and the second energy gap is greater than 6.6 eV. The second energy gap is, for example, equal to or greater than 1.4 times the first energy gap. The second energy gap is, for example, greater than twice a photon energy of the laser beam 19. The photon energy E (eV) of the laser beam 19 is given by Equation (1). Where h represents the Planck's constant, c represents the speed of light in vacuum, e represents the amount of charge, and λ represents the wavelength of the laser beam 19.

[Math. 1]

$$E(eV) = \frac{hc}{e\lambda} \qquad (1)$$

The first glass material is, for example, BK7. BK7 has an energy gap in the range of 4.5 eV to 5.7 eV. The second glass material is, for example, synthetic quartz. Synthetic quartz has an energy gap in the range of 8 eV to 9 eV.

BK7 and synthetic quartz have high transmittance to light having a wavelength in the visible region (for example, a wavelength in the range of 380 nm to 750 nm). BK7 is lower in material cost and is easier to be processed than synthetic quartz. Therefore, it is possible to manufacture a lens at a lower cost from BK7 than from synthetic quartz. The refractive index of BK7 is greater than the refractive index of synthetic quartz. Therefore, BK7 can reduce the size of a single lens and the size of an optical system including a lens as compared with synthetic quartz. The temperature coefficient of the refractive index of BK7 is 2.6 ppm/°C, and the temperature coefficient of the refractive index of synthetic quartz is 10.6 ppm/°C. The temperature change of the refractive index of BK7 is smaller than the temperature coefficient of the refractive index of synthetic quartz. By using BK7 as the glass material of the lens, it is possible to reduce a variation of power of the laser beam output from the laser beam irradiation apparatus with respect to the temperature change of the laser beam irradiation apparatus.

The reduction optical system 22 may reduce the interval between the plurality of laser beams 19 in both the fast axis direction (x direction) and the slow axis direction (y direction), and may reduce the beam size (for example, the beam diameter) of each of the plurality of laser beams 19 in both the fast axis direction (x direction) and the slow axis direction (y direction). Such a reduction optical system 22 is suitable, for example, when each of the plurality of laser beams 19 has a circular cross-sectional shape.

The condenser lens 26 is disposed between the reduction optical system 22 and the optical fiber 30. The condenser lens 26 condenses the laser beam 19 emitted from the reduction optical system 22 onto a core 31 of the optical fiber 30. The condenser lens 26 is, for example, a biconvex positive lens. The condenser lens 26 is made of, for example, the same glass material as the lens 24a. In other words, the condenser lens 26 is made of, for example, the second glass material.

The optical fiber 30 includes a core 31 and a cladding material 32. The core 31 is surrounded by the cladding material 32. The core 31 has a refractive index greater than that of the cladding material 32. The plurality of laser beams 19 emitted from the plurality of laser light sources 10 propagate through the core 31. The plurality of laser beams 19 are multiplexed in the core 31 and emitted from the core 31 as a laser beam 35. The optical fiber 30 is, for example, a quartz optical fiber. When the optical fiber 30 is disposed in the air, the numerical aperture NA of the optical fiber 30 and the maximum incident angle $\theta_{max}$ of a light beam that can be coupled to the optical fiber 30 are given by Equation (2). $N_{core}$

represents the refractive index of the core 31, and $n_{clad}$ represents the refractive index of the cladding material 32.
[Math. 2]

$$NA = sin\theta_{max} = \sqrt{(n_{core}^2 - n_{clad}^2)} \qquad (2)$$

[Modification]

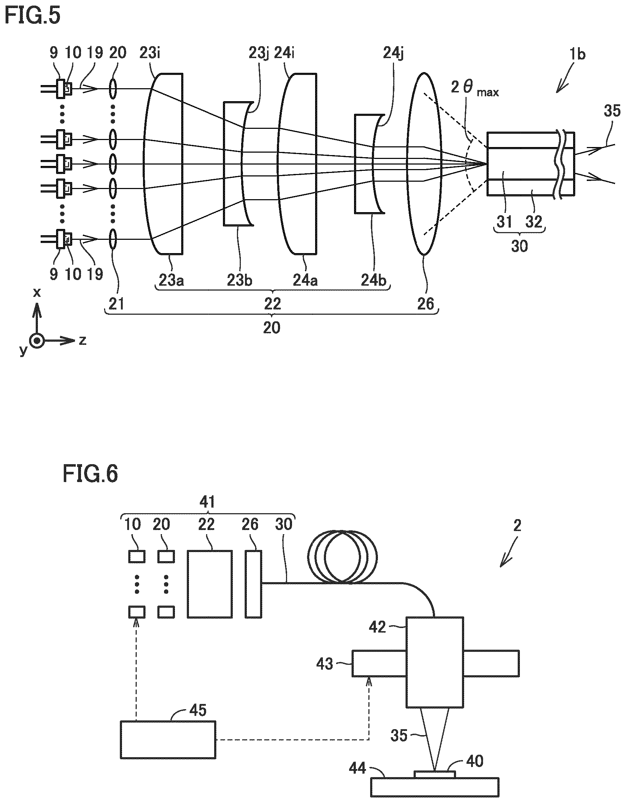

A laser beam irradiation apparatus 1b according to a modification of the present embodiment will be described with reference to Fig. 5. The laser beam irradiation apparatus 1b has substantially the same configuration as the laser beam irradiation apparatus 1, but is different from the laser beam irradiation apparatus 1 in that the reduction optical system 22 includes a plurality of lenses 23a and 23b and a plurality of lenses 24a and 24b. In the laser beam irradiation apparatus 1b, the plurality of lenses 23a and 23b constitute a first reduction optical system, and the plurality of lenses 24a and 24b constitute a second reduction optical system. Therefore, the reduction optical system 22 includes a first reduction optical system and a second reduction optical system. The first reduction optical system and the second reduction optical system are arranged in series along the optical axis of each of the plurality of laser beams 19. Therefore, even if the number of the plurality of laser light sources 10 is increased, the reduction optical system 22 allows the plurality of laser beams 19 to enter within the numerical aperture NA of the optical fiber 30.

The input surface 23i of the plurality of lenses 23a and 23b is the same as the input surface of the lens 23a. The exit surface 23j of the plurality of lenses 23a and 23b is the same as the exit surface of the lens 23b. The lens 23a has positive power. The lens 23a is, for example, a plano-convex lens having a convex surface facing the plurality of laser light sources 10. The lens 23b has negative power. The lens 23b is, for example, a plano-concave lens having a concave surface facing the optical fiber 30.

The input surface 24i of the plurality of lenses 24a and 24b is the same as the input surface of the lens 24a. The exit surface 24j of the plurality of lenses 24a and 24b is the same as the exit surface of the lens 24b. The lens 24a has positive power. The lens 24a is, for example, a plano-convex lens having a convex surface facing the plurality of laser light sources 10. The lens 24b has negative power. The lens 24b is, for example, a plano-concave lens having a concave surface facing the optical fiber 30.

The plurality of lenses 23a and 23b reduce the interval between the plurality of laser beams 19 in the fast axis direction (x direction) and reduce the beam size (for example, the beam diameter) of each of the plurality of laser beams 19 in the fast axis direction. The plurality of lenses 24a and 24b also reduce the interval between the plurality of laser beams 19 in the fast axis direction (x direction) and reduce the beam size (for example, the beam diameter) of each of the plurality of laser beams 19 in the fast axis direction. Therefore, the second beam cross-sectional area of each of the plurality of laser beams 19 on the exit surface 24j of each of the plurality of lenses 24a and 24b is smaller than the first beam cross-sectional area of each of the plurality of laser beams 19 on the input surface 23i of each of the plurality of lenses 23a and 23b.

The second power density of the laser beam 19 on the exit surface 24j of the plurality of lenses 24a and 24b is greater than the first power density of the laser beam 19 on the input surface 23i of the plurality of lenses 23a and 23b. The first power density of the laser beam 19 on the input surface 23i of the plurality of lenses 23a and 23b is, for example, less than 300 W/cm$^2$. The second power density of the laser beam 19 on the exit surface 24j of each of the plurality of lenses 24a and 24b is, for example, 300 W/cm$^2$ or more. The second power density of the laser beam 19 on the exit surface 24j of each of the plurality of lenses 24a and 24b is, for example, equal to or greater than twice the first power density of the laser beam 19 on the input surface 23i of each of the plurality of lenses 23a and 23b.

The plurality of lenses 23a and 23b are made of the first glass material. The number of lenses made of the first glass material is not limited to two, and may be three or more. The plurality of lenses 24a and 24b are not limited to two, and are made of the second glass material. The number of lenses made of the second glass material may be three or more. The second energy gap of the second glass material is greater than the first energy gap of the first glass material. For example, the first energy gap is equal to or less than 6.6 eV, and the second energy gap is greater than 6.6 eV. The second energy gap is, for example, equal to or greater than 1.4 times the first energy gap. The second energy gap is, for example, greater than twice the photon energy of the laser beam 19. The first glass material is, for example, BK7. The second glass material is, for example, synthetic quartz.

The plurality of lenses 23a and 23b may reduce the interval between the plurality of laser beams 19 in both the fast axis direction (x direction) and the slow axis direction (y direction), and may reduce the beam size (for example, the beam diameter) of each of the plurality of laser beams 19 in both the fast axis direction (x direction) and the slow axis direction (y direction). The plurality of lenses 24a and 24b may reduce the interval between the plurality of laser beams 19 in both the fast axis direction (x direction) and the slow axis direction (y direction), and may reduce the beam size (for example, the beam diameter) of each of the plurality of laser beams 19 in both the fast axis direction (x direction) and the slow axis direction (y direction). Such a reduction optical system 22 is suitable, for example, when each of the plurality of laser beams 19 has a circular cross-sectional shape.

A laser processing apparatus 2 according to the present embodiment will be described with reference to Fig. 6. The laser processing apparatus 2 processes the workpiece 40 using the laser beam 35. Specifically, the workpiece 40 is heated by irradiating the workpiece 40 with the laser beam 35. The material constituting the workpiece 40 is melted or evaporated. In this way, the workpiece 40 is processed using the laser beam 35. In the present specification, the laser processing includes, for example, welding, cutting, and forming a recess in the workpiece 40. The laser processing apparatus 2 includes a laser beam irradiation apparatus 41, an irradiation mechanism 42, a moving mechanism 43, a workpiece mounting table 44, and a controller 45.

The laser beam irradiation apparatus 41 is the same as the laser beam irradiation apparatus 1 (see Fig. 1) or the laser beam irradiation apparatus 1b (see Fig. 5). The workpiece 40 is mounted on the workpiece mounting table 44. The irradiation mechanism 42 includes a condenser lens (not shown). The irradiation mechanism 42 condenses the laser beam 35 emitted from the optical fiber 30 by using the condenser lens and irradiates the workpiece 40 with the condensed laser beam. The moving mechanism 43 includes a motor (not shown). The moving mechanism 43 moves the irradiation mechanism 42 to a region on the workpiece 40 to be irradiated with the laser beam 35.

The controller 45 controls the laser beam irradiation apparatus 41 and the moving mechanism 43. For example, the controller 45 controls the plurality of laser light sources 10 included in the laser light irradiation apparatus 41. The controller 45 controls the motor included in the moving mechanism 43.

The controller 45 is, for example, a microcomputer that includes a processor, a random access memory (RAM), and a storage device such as a read only memory (ROM). As the processor, for example, a central processing unit (CPU) may be employed. The RAM functions as a working memory that temporarily stores data to be processed by the processor. The storage device stores, for example, a program to be executed by the processor. When the processor executes the program stored in the storage device, the controller 45 controls the laser beam irradiation apparatus 41 and the moving mechanism 43. Various processes in the controller 45 are not limited to being executed by software, and may be executed by dedicated hardware (electronic circuits).

[Effects of the Present Embodiment]

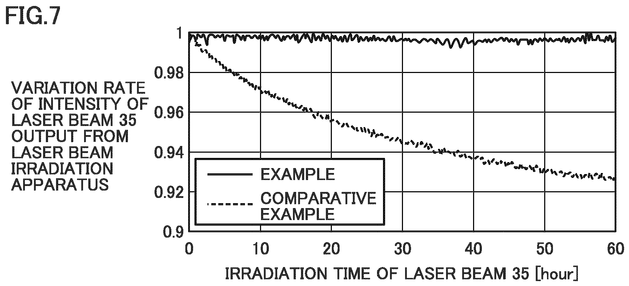

With reference to Fig. 7, the effects of the laser beam irradiation apparatus 1 or 1b according to the present embodiment will be described by comparing the laser beam irradiation apparatus according to an example with the laser beam irradiation apparatus according to a comparative example. The laser beam irradiation apparatus according to the example is configured in the same manner as the laser beam irradiation apparatus 1b according to the modification of the present embodiment. In the laser beam irradiation apparatus according to the example, the plurality of laser light sources 10 are blue laser diodes that emit a blue laser beam, the first glass material is BK7, the second glass material is synthetic quartz, the first power density of the laser beam 19 on the input surface 23i of the plurality of lenses 23a and 23b is 231 $W/cm^2$, and the second power density of the laser beam 19 on the exit surface 24j of the plurality of lenses 24a and 24b is 486 $W/cm^2$. The laser beam irradiation apparatus according to the comparative example is configured in the same manner as the laser beam irradiation apparatus of the example, but in the laser beam irradiation apparatus according to the comparative example, the first glass material and the second glass material are BK7.

As illustrated in Fig. 7, in the laser beam irradiation apparatus according to the comparative example, as the irradiation time of the laser beam 35 becomes longer, the intensity of the laser beam 35 output from the optical fiber 30 greatly decreases. The reason therefor is considered as follows.

The bandgap energy of BK7 is greater than the photon energy of laser beam 19. Therefore, the BK7 is substantially transparent to the laser beam 19 and does not absorb the laser beam 19. However, the bandgap energy of BK7 is smaller than twice the photon energy of laser beam 19. Therefore, when the optical output of each of the plurality of laser light sources 10 increases and thereby the power density of the laser beam 19 on the plurality of lenses 24a and 24b increases, two-photon absorption occurs in the plurality of lenses 24a and 24b. The two-photon absorption breaks chemical bonds of the glass material constituting the plurality of lenses 24a and 24b, which increases the density of the glass material in the plurality of lenses 24a and 24b. The refractive index of the plurality of lenses 24a and 24b increases, and thereby the coupling efficiency of the laser beam 19 from the coupling optical system 20 to the optical fiber 30 decreases. The laser beam 19 emitted from each of the plurality of laser light sources 10 cannot be stably coupled to the optical fiber 30 over a longer period of time. Thus, the intensity of the laser beam 35 output from the optical fiber 30 greatly decreases.

On the other hand, in the laser beam irradiation apparatus according to the example, even if the irradiation time of the laser beam 35 becomes long, the intensity of the laser beam 35 output from the optical fiber 30 is prevented from decreasing. The reason therefor is considered as follows.

The bandgap energy of the synthetic quartz is greater than twice the photon energy of the laser beam 19. Therefore, even if the optical output of each of the plurality of laser light sources 10 increases and thereby the power density of the laser beam 19 on the plurality of lenses 24a and 24b increases, two-photon absorption does not occur in the plurality of lenses 24a and 24b. Even if the irradiation time of the laser beam 35 becomes long, the refractive index of the plurality of lenses 24a and 24b hardly changes, and thereby the coupling efficiency of the laser beam 19 from the coupling optical system 20 to the optical fiber 30 hardly changes. The laser beam 19 emitted from each of the plurality of laser light sources 10 can be stably coupled to the optical fiber 30 over a longer period of time. Thus, the intensity of the laser beam 35 output from the optical fiber 30 is prevented from decreasing.

[Aspects]

It will be understood by those skilled in the art that the exemplary embodiments described above are specific examples of the following aspects.

(First Aspect) A laser beam irradiation apparatus according to a first aspect includes a plurality of laser light sources, an optical fiber, and a coupling optical system. The plurality of laser light sources each emit a laser beam. The coupling optical system is disposed between the plurality of laser light sources and the optical fiber, and couples the laser beam to the optical fiber. The coupling optics include a reduction optical system. The reduction optical system includes a first lens and a second lens. The first lens is disposed closer to the plurality of laser light sources than the second lens on an optical path of the laser beam. A second beam cross-sectional area of the laser beam on an exit surface of the second lens is smaller than a first beam cross-sectional area of the laser beam on an input surface of the first lens. The first lens is made of a first glass material. The second lens is made of a second glass material. A second energy gap of the second glass material is greater than a first energy gap of the first glass material.

Therefore, even if the irradiation time of the laser beam becomes long, the refractive index of the second lens hardly changes, and thereby the coupling efficiency of the laser beam from the coupling optical system to the optical fiber hardly changes. The laser beam emitted from each of the plurality of laser light sources can be stably coupled to the optical fiber over a longer period of time.

(Second Aspect) In the laser beam irradiation apparatus according to the first aspect, the laser beam has a wavelength of 380 nm or more and 550 nm or less, the first energy gap is 6.6 eV or less, and the second energy gap is greater than 6.6 eV.

Therefore, even if the irradiation time of the laser beam becomes long, the refractive index of the second lens hardly changes, and thereby the coupling efficiency of the laser beam from the coupling optical system to the optical fiber hardly changes. The laser beam emitted from each of the plurality of laser light sources can be stably coupled to the optical fiber over a longer period of time.

(Third Aspect) In the laser beam irradiation apparatus according to the first or second aspect, the second glass material is synthetic quartz.

Therefore, even if the irradiation time of the laser beam becomes long, the refractive index of the second lens hardly changes, and thereby the coupling efficiency of the laser beam from the coupling optical system to the optical fiber hardly changes. The laser beam emitted from each of the plurality of laser light sources can be stably coupled to the optical fiber over a longer period of time.

(Fourth Aspect) In the laser beam irradiation apparatus according to any one of the first to third aspects, the first glass material is BK7.

BK7 is lower in material cost and is easier to be processed than synthetic quartz. The refractive index of BK7 is higher than the refractive index of synthetic quartz. Therefore, the cost and size of the coupling optical system can be reduced, and thereby the cost and size of the laser irradiation apparatus can be reduced.

(Fifth Aspect) In the laser beam irradiation apparatus according to any one of the first to fourth aspects, the plurality of laser light sources are a plurality of laser diodes.

Therefore, the cost and size of the laser irradiation apparatus can be reduced.

(Sixth Aspect) In the laser beam irradiation apparatus according to any one of the first to fifth aspects, the second energy gap is greater than twice the photon energy of the laser beam.

Therefore, even if the irradiation time of the laser beam becomes long, the refractive index of the second lens hardly changes, and thereby the coupling efficiency of the laser beam from the coupling optical system to the optical fiber hardly changes. The laser beam emitted from each of the plurality of laser light sources can be stably coupled to the optical fiber over a longer period of time.

(Seventh Aspect) In the laser beam irradiation apparatus according to any one of the first to fifth aspects, the second energy gap is equal to or greater than 1.4 times the first energy gap.

Therefore, even if the irradiation time of the laser beam becomes long, the refractive index of the second lens hardly changes, and thereby the coupling efficiency of the laser beam from the coupling optical system to the optical fiber hardly changes. The laser beam emitted from each of the plurality of laser light sources can be stably coupled to the optical fiber over a longer period of time.

(Eighth Aspect) In the laser beam irradiation apparatus according to any one of the first to seventh aspects, the second power density of the laser beam on the exit surface of the second lens is equal to or greater than twice the first power density of the laser beam on the input surface of the first lens.

Even if the power density of the laser beam on the second lens increases, the refractive index of the second lens hardly changes, and thereby the coupling efficiency of the laser beam from the coupling optical system to the optical fiber hardly changes. The laser beam emitted from each of the plurality of laser light sources can be stably coupled to the optical fiber over a longer period of time.

(Ninth Aspect) In the laser beam irradiation apparatus according to any one of the first to eighth aspects, the coupling optical system includes a condenser lens. The condenser lens is disposed between the reduction optical system and the optical fiber, and is made of the second glass material.

Therefore, the laser beam emitted from each of the plurality of laser light sources can be coupled to the optical fiber with higher coupling efficiency.

(Tenth Aspect) In the laser beam irradiation apparatus according to any one of the first to ninth aspects, the coupling optical system includes a plurality of collimating lenses. The plurality of collimating lenses are disposed between the plurality of laser light sources and the reduction optical system, and are made of the first glass material.

Therefore, the laser beam emitted from each of the plurality of laser light sources can be coupled to the optical fiber with higher coupling efficiency.

(Eleventh Aspect) A laser processing apparatus according to an eleventh aspect includes the laser beam irradiation apparatus according to any one of the first to tenth aspects.

In the laser beam irradiation apparatus, the laser beam emitted from each of the plurality of laser light sources can be stably coupled to the optical fiber over a longer period of time. Therefore, according to the laser processing apparatus, the workpiece can be stably processed over a longer period of time.

It should be understood that the embodiments disclosed herein are illustrative and non-restrictive in all respects. The scope of the present invention is defined by the terms of the claims rather than the description of the embodiments above, and is intended to include any modifications within the scope and meaning equivalent to the terms of the claims.

1, 1b, 41: laser beam irradiation apparatus; 2: laser processing apparatus; 9: package; 10: laser light source; 11: substrate; 12: lower cladding layer; 13: active layer; 14: upper cladding layer; 15, 16: electrode; 17: insulating layer; 19, 35: laser beam; 20: coupling optical system; 21: collimating lens; 22: reduction optical system; 23a, 23b: lens; 23i: input surface; 23j: exit surface; 24a, 24b: lens; 24i: input surface; 24j: exit surface; 26: condenser lens; 30: optical fiber; 31: core; 32: cladding material; 40: workpiece; 42: irradiation mechanism; 43: moving mechanism; 44: workpiece mounting table; 45: controller.

**Claims**

1. A laser beam irradiation apparatus comprising:

   a plurality of laser light sources, the plurality of laser light sources each emitting a laser beam;
   an optical fiber; and
   a coupling optical system that is disposed between the plurality of laser light sources and the optical fiber and couples the laser beam to the optical fiber,
   wherein the coupling optical system includes a reduction optical system,
   the reduction optical system includes a first lens and a second lens,
   the first lens is disposed closer to the plurality of laser light sources than the second lens on an optical path of the laser beam,
   a second beam cross-sectional area of the laser beam on an exit surface of the second lens is smaller than a first beam cross-sectional area of the laser beam on an input surface of the first lens,
   the first lens is made of a first glass material,
   the second lens is made of a second glass material, and
   a second energy gap of the second glass material is greater than a first energy gap of the first glass material.

2. The laser beam irradiation apparatus according to claim 1, wherein the laser beam has a wavelength of 380 nm or more and 550 nm or less,

   the first energy gap is 6.6 eV or less, and
   the second energy gap is greater than 6.6 eV.

3. The laser beam irradiation apparatus according to claim 1, wherein the second glass material is synthetic quartz.

4. The laser beam irradiation apparatus according to claim 1, wherein the first glass material is BK7.

5. The laser beam irradiation apparatus according to claim 1, wherein
the plurality of laser light sources are a plurality of laser diodes.

6. The laser beam irradiation apparatus according to claim 1, wherein
the second energy gap is greater than twice a photon energy of the laser beam.

7. The laser beam irradiation apparatus according to claim 1, wherein
the second energy gap is equal to or greater than 1.4 times the first energy gap.

8. The laser beam irradiation apparatus according to claim 1, wherein
a second power density of the laser beam on the exit surface of the second lens is equal to or greater than twice a first power density of the laser beam on the input surface of the first lens.

9. The laser beam irradiation apparatus according to claim 1, wherein

the coupling optical system includes a condenser lens, and
the condenser lens is disposed between the reduction optical system and the optical fiber, and is made of the second glass material.

10. The laser beam irradiation apparatus according to claim 1, wherein

the coupling optical system includes a plurality of collimating lenses, and
the plurality of collimating lenses are disposed between the plurality of laser light sources and the reduction optical system, and are made of the first glass material.

11. A laser processing apparatus comprising:
the laser beam irradiation apparatus according to claim 1.

FIG.1

FIG.2

FIG.3

RELATIVE LIGHT INTENSITY

POSITION IN FAST AXIS DIRECTION

FIG.4

RELATIVE LIGHT INTENSITY

POSITION IN SLOW AXIS DIRECTION

**FIG.5**

**FIG.6**

FIG.7

VARIATION RATE
OF INTENSITY OF
LASER BEAM 35
OUTPUT FROM
LASER BEAM
IRRADIATION
APPARATUS

IRRADIATION TIME OF LASER BEAM 35 [hour]

# EP 4 535 054 A1

## INTERNATIONAL SEARCH REPORT

| | International application No. |
|---|---|
| | **PCT/JP2023/018220** |

### A. CLASSIFICATION OF SUBJECT MATTER

***G02B 6/32***(2006.01)i; ***B23K 26/064***(2014.01)i; ***G02B 6/42***(2006.01)i; ***H01S 5/40***(2006.01)i
FI: G02B6/32; B23K26/064 K; G02B6/42; H01S5/40

According to International Patent Classification (IPC) or to both national classification and IPC

### B. FIELDS SEARCHED

Minimum documentation searched (classification system followed by classification symbols)

G02B6/26-6/27; G02B6/30-6/34; G02B6/42-6/43; H01S5/00-5/50; B23K26/00-26/70

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2021-167911 A (SHIMADZU CORP.) 21 October 2021 (2021-10-21) paragraphs [0010]-[0046], [0054]-[0056], fig. 1-4, 6 | 1-11 |
| Y | WO 2016/046954 A1 (MITSUBISHI ELECTRIC CORP.) 31 March 2016 (2016-03-31) paragraphs [0033], [0034] | 1-11 |
| A | WO 2004/020140 A1 (SUMITOMO HEAVY INDUSTRIES, LTD.) 11 March 2004 (2004-03-11) entire text, all drawings | 1-11 |
| A | WO 2017/002149 A1 (OLYMPUS CORP.) 05 January 2017 (2017-01-05) entire text, all drawings | 1-11 |
| A | JP 2018-153846 A (FUJIKURA LTD.) 04 October 2018 (2018-10-04) entire text, all drawings | 1-11 |
| A | US 2014/0211466 A1 (DEWA, Paul Gerard et al.) 31 July 2014 (2014-07-31) entire text, all drawings | 1-11 |

☐ Further documents are listed in the continuation of Box C.    ☑ See patent family annex.

| | |
|---|---|
| *   Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **14 July 2023** | **01 August 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
**Information on patent family members**

International application No.

**PCT/JP2023/018220**

| Patent document cited in search report | | | Publication date (day/month/year) | Patent family member(s) | | Publication date (day/month/year) |
|---|---|---|---|---|---|---|
| JP | 2021-167911 | A | 21 October 2021 | (Family: none) | | |
| WO | 2016/046954 | A1 | 31 March 2016 | (Family: none) | | |
| WO | 2004/020140 | A1 | 11 March 2004 | US 2005/0155956 entire text, all drawings TW 200408486 KR 10-2005-0059103 CN 1678426 | A1 A A A | |
| WO | 2017/002149 | A1 | 05 January 2017 | US 2018/0100971 entire text, all drawings CN 107735708 | A1 A | |
| JP | 2018-153846 | A | 04 October 2018 | US 2018/0264597 entire text, all drawings CN 108620726 | A1 A | |
| US | 2014/0211466 | A1 | 31 July 2014 | (Family: none) | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007163947 A